(19) Europäisches Patentamt / European Patent Office / Office européen des brevets

(11) **EP 2 109 861 B1**

(12) **EUROPEAN PATENT SPECIFICATION**

(45) Date of publication and mention
of the grant of the patent:
**13.03.2019 Bulletin 2019/11**

(21) Application number: **08700207.7**

(22) Date of filing: **07.01.2008**

(51) Int Cl.:
***G10L 19/26*** *(2013.01)*        *G10L 19/008* *(2013.01)*
*G10L 19/20* *(2013.01)*

(86) International application number:
**PCT/IB2008/050029**

(87) International publication number:
**WO 2008/084427 (17.07.2008 Gazette 2008/29)**

(54) **AUDIO DECODER**

AUDIODEKODER

DÉCODEUR AUDIO

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **10.01.2007 EP 07100339**

(43) Date of publication of application:
**21.10.2009 Bulletin 2009/43**

(73) Proprietor: **Koninklijke Philips N.V.
5656 AE Eindhoven (NL)**

(72) Inventor: **BREEBAART, Dirk, J.
NL-5656 AE Eindhoven (NL)**

(74) Representative: **de Haan, Poul Erik et al
Philips International B.V.
Philips Intellectual Property & Standards
High Tech Campus 5
5656 AE Eindhoven (NL)**

(56) References cited:
**EP-A- 1 565 036     US-A1- 2003 035 553**

• **BREEBART J ET AL: "MPEG Spatial Audio
Coding / MPEG surround: Overview and Current
Status" AUDIO ENGINEERING SOCIETY
CONVENTION PAPER, NEW YORK, NY, US, 7
October 2005 (2005-10-07), pages 1-17,
XP002379094**
• **FALLER C ET AL: "Binaural Cue Coding -Part II:
Schemes and Applications" IEEE
TRANSACTIONS ON SPEECH AND AUDIO
PROCESSING, IEEE SERVICE CENTER, NEW
YORK, NY, US, vol. 11, no. 6, 6 October 2003
(2003-10-06), pages 520-531, XP002338415 ISSN:
1063-6676**

**EP 2 109 861 B1**

**Description**

TECHNICAL FIELD

The invention relates to an audio decoder in particular, but not exclusively, to an MPEG Surround decoder or object-oriented decoder.

TECHNICAL BACKGROUND

In (parametric) spatial audio (en)coders, parameters are extracted from the original audio signals so as to produce a reduced number of down-mix audio signals (for example only a single down-mix signal corresponding to a mono, or two down-mix signals for a stereo down mix), and a corresponding set of parameters describing the spatial properties of the original audio signal. In (parametric) spatial audio decoders, the spatial properties described by the transmitted spatial parameters are used to recreate a spatial multi-channel signal, which closely resembles the original multi-channel audio signal.

Recently, techniques for processing and manipulating of individual audio objects at the decoding side have attracted significant interest. For example, within the MPEG framework, a workgroup has been started on object-based spatial audio coding. The aim of this workgroup is to "explore new technology and reuse of current MPEG Surround components and technologies for the bit rate efficient coding of multiple sound sources or objects into a number of down-mix channels and corresponding spatial parameters". In other words, the aim is to encode multiple audio objects in a limited set of down-mix channels with corresponding parameters. At the decoder side, users interact with the content for example by repositioning the individual objects.

Such interaction with the content is easily realized in object-oriented decoders. It is then realized by including a rendering that follows the decoding. Said rendering is combined with the decoding to prevent the need of determining individual objects. The currently available dedicated rendering comprises positioning of objects, volume adjusting, or equalization of the rendered audio signals.

EP 1 565 036 A2 describes a decoder that allows a reverberation effect to be applied to an audio signal during rendering of an auditory scene.

One disadvantage of the known object-oriented decoders with the incorporated rendering is that they permit a limited set of manipulations of objects, because they do not produce or operate on the individual objects. On the other hand explicit decoding of the individual audio objects is very costly and inefficient.

SUMMARY OF THE INVENTION

It is an object of the invention to provide an enhanced decoder for decoding audio objects that allows a wider range of manipulations of objects without a need for decoding the individual audio objects for this purpose.

This object is achieved by an audio decoder according to the invention. It is assumed that a set of objects, each with its corresponding waveform, has previously been encoded in an object-oriented encoder, which generates a down-mix audio signal (a single signal in case of a single channel), said down-mix audio signal being a down-mix of a plurality of audio objects and corresponding parametric data. The parametric data comprises a set of object parameters for each of the different audio objects. The receiver receives said down-mix audio signal and said parametric data. This down-mix audio signal is further fed into effect means that generate modified down-mix audio signal by applying effects to estimates of audio signals corresponding to selected audio objects comprised in the down-mix audio signal. Said estimates of audio signals are derived based on the parametric data. The modified down-mix audio signal is further fed into decoding means, or rendering means, or combined with the output of rendering means depending on a type of the applied effect, e.g. an insert or send effect. The decoding means decode the audio objects from the down-mix audio signal fed into the decoding means, said down-mix audio signal being the originally received down-mix audio signal or the modified down-mix audio signal. Said decoding is performed based on the parametric data. The rendering means generate a spatial output audio signal from the audio objects obtained from the decoding means and optionally from the effect means, depending on the type of the applied effect.

The advantage of the decoder according to the invention is that in order to apply various types of effects it is not needed that the object, to which the effect is to be applied, is available. Instead, the invention proposes to apply the effect to the estimated audio signals corresponding to the objects before or in parallel to the actual decoding. Therefore, explicit object decoding is not required, and the rendering emerged in the decoder is preserved.

In an embodiment, the decoder further comprises modifying means for modifying the parametric data when a spectral or temporal envelope of an estimated audio signal corresponding to the object or plurality of objects is modified by the insert effect.

An example of such an effect is a non-linear distortion that generates additional high frequency spectral com-

2

ponents, or a multi-band compressor. If the spectral characteristic of the modified audio signal has changed, applying the unmodified parameters comprised in the parametric data, as received, might lead to undesired and possibly annoying artifacts. Therefore, adapting the parameters to match the new spectral or temporal characteristics improves the quality of the resulting rendered audio signal.

The generation of the estimated audio signals corresponding to an audio object or plurality of objects comprises time/frequency dependent scaling of the down-mix audio signals based on the power parameters corresponding to audio objects, said power parameters being comprised in the received parametric data.

The advantage of this estimation is that it comprises a multiplication of the down-mix audio signal. This makes the estimation process simple and efficient.

In an embodiment, the decoding means comprise a decoder in accordance with the MPEG Surround standard and conversion means for converting the parametric data into parametric data in accordance with the MPEG Surround standard.

The advantage of using the MPEG Surround decoder is that this type of decoder is used as a rendering engine for an object-oriented decoder. In this case, the object-oriented parameters are combined with user-control data and converted to MPEG Surround parameters, such as level differences and correlation parameters between channels (pairs). Hence the MPEG Surround parameters result from the combined effect of object-oriented parameters, i.e. transmitted information, and the desired rendering properties, i.e. user-controllable information set at the decoder side. In such a case no intermediate object signals are required.

The invention further provides a receiver and a communication system, as well as corresponding methods.

In an embodiment, the insert and send effects are applied simultaneously. Using of, for example, insert effects does not exclude use of send effects, and vice versa.

The invention further provides a computer program product enabling a programmable device to perform the method according to the invention.

## BRIEF DESCRIPTION OF THE DRAWINGS

These and other aspects of the invention will be apparent from and elucidated with reference to the embodiments shown in the drawings, in which:

Fig 1A schematically shows an object-oriented decoder;
Fig 1B schematically shows an object-oriented decoder according to the invention;
Fig 2 shows an example of effect means for an insert effect;
Fig 3 shows modifying means for modifying the parametric data when a spectral envelope of an estimated audio signal corresponding to the object or plurality of objects is modified by the insert effect;
Fig 4 shows an example of effect means for a send effect;
Fig 5 shows decoding means the decoding means comprise a decoder in accordance with the MPEG Surround standard and conversion means for converting the parametric data into parametric data in accordance with the MPEG Surround standard;
Fig 6 shows a transmission system for communication of an audio signal in accordance with some embodiments of the invention.

Throughout the figures, same reference numerals indicate similar or corresponding features. Some of the features indicated in the drawings are typically implemented in software, and as such represent software entities, such as software modules or objects.

## DETAILED DESCRIPTION OF THE PREFERRED EMBODIMENTS

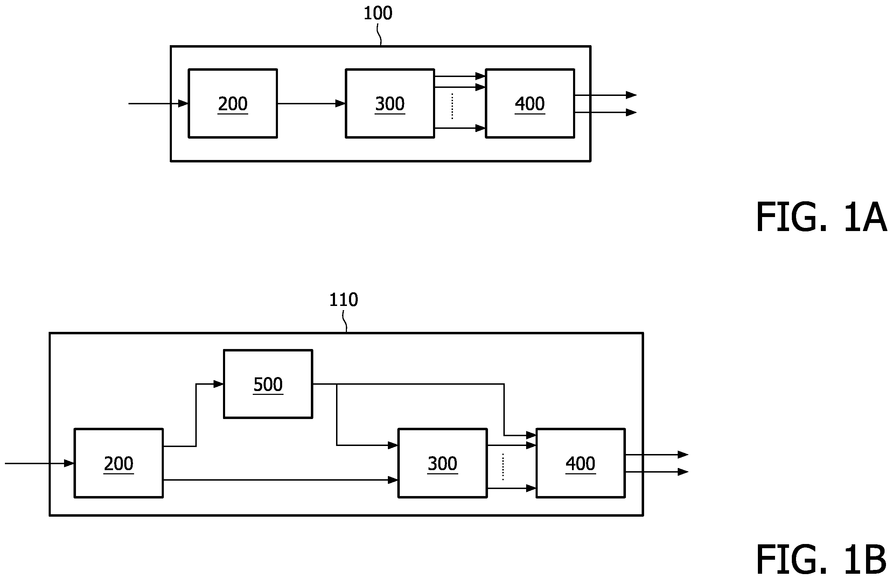

Fig 1A schematically shows an object-oriented decoder 100 as known for example from C. Faller: "Parametric Joint-Coding of Audio Sources", AES 120th Convention, Paris, France, Preprint 6752, May 2006. It is assumed that a set of objects, each with its corresponding waveform, has previously been encoded in an object-oriented encoder, which generates a down-mix audio signal (a single signal in case of a single channel, or two signals in case of two channels (= stereo)), said down-mix audio signal being a down-mix of a plurality of audio objects characterized by corresponding parametric data. The parametric data comprises a set of object parameters for each of the different audio objects. The receiver 200 receives said down-mix audio signal and said parametric data.

The signal fed into the receiver 200 is a single signal that corresponds to the stream of multiplexed down-mix audio data that corresponds to the down-mix audio signal and the parametric data. The function of the receiver is then demultiplexing of the two data streams. If the down-mix audio signal is provided in compressed form (such as MPEG-1 layer 3), receiver 200 also performs decompression or decoding of the compressed audio signal into a time-domain audio down-mix signal.

Although, the input of the receiver 200 is depicted a single signal/data path it could also comprise multiple data paths for separate down-mix signals and/or parametric data. Consequently the down-mix signals and the parametric data are fed into decoding means 300 that decode the audio objects from the down-mix audio signals based on the parametric data. The decoded audio objects are further fed into rendering means 400 for generating at least one output audio signal from the decoded audio objects. Although, the decoding means and rendering means are drawn as separate units, they very often are merged together. As a result of such merger of the decoding and rendering processing means there is no need for explicit decoding of individual audio objects. Instead rendered audio signals are provided at the much lower computational cost, and with no loss of audio quality.

Fig 1B schematically shows an object-oriented decoder 110 according to the invention. The receiver 200 receives said down-mix audio signal and said parametric data. This down-mix audio signal and the parametric data are further fed into effect means 500 that generate modified down-mix audio signal by applying effects to estimates of audio signals corresponding to selected audio objects comprised in the down-mix audio signal. Said estimates of audio signals are derived based on the parametric data. The modified down-mix audio signal is further fed into decoding means 300, or rendering means 400, or combined with the output of rendering means depending on a type of the applied effect, e.g. an insert or send effect. The decoding means 300 decode the audio objects from the down-mix audio signal fed into the decoding means, said down-mix audio signal being the originally received down-mix audio signal or the modified down-mix audio signal. Said decoding is performed based on the parametric data. The rendering means 400 generate a spatial output audio signal from the audio objects obtained from the decoding means 300 and optionally from the effect means 400, depending on the type of the applied effect.

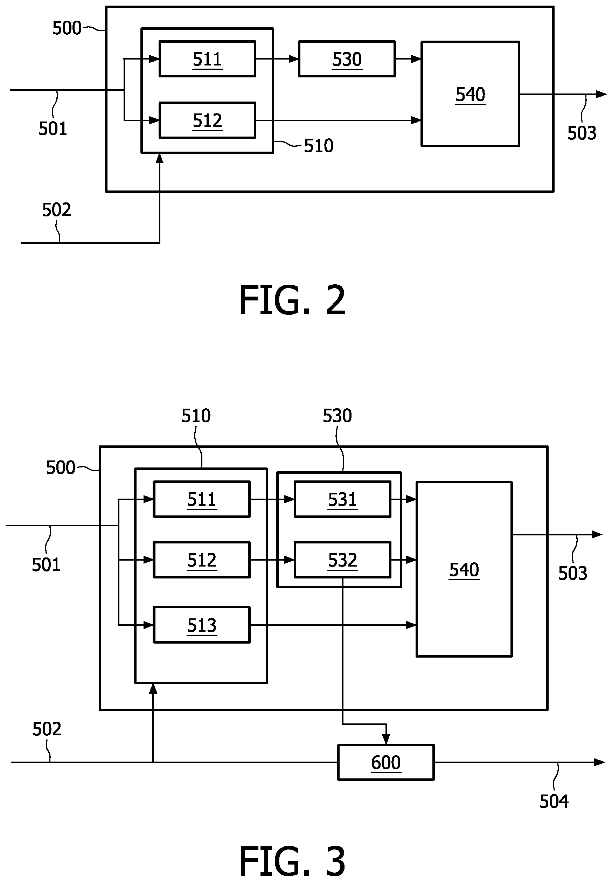

Fig 2 shows an example of effect means 500 for an insert effect. The down-mix signals 501 are fed into the effect means 500; these signals are fed in parallel to units 511 and 512 that are comprised in estimation means 510. The estimation means 510 generate the estimated audio signals corresponding to an object or plurality of objects to which the insert effect is to be applied, and the estimated audio signal corresponding to the remaining objects. The estimation of audio signals corresponding to an object or plurality of objects to which the insert effect is to be applied is performed by the unit 511, while the estimation of the audio signal corresponding to the remaining objects is performed by the unit 512. Said estimation is based on the parametric data 502 that is obtained from the receiver 200. Consequently the insert effect is applied by insert means 530 on the estimated audio signals corresponding to an object or plurality of objects to which the insert effect is to be applied. An adder 540 adds up the audio signals provided from the insert means 530 and the estimated audio signal corresponding to the remaining objects, therefore assembling again all the objects together. The resulting modified down-mix signal 503 is further fed into the decoding means 300 of the object-oriented decoder 110. In the remainder of the text whenever units 200, 300, or 400 are referred to they are comprised in an object-oriented decoder 110.

The examples of insert effects are among others: dynamic range compression, generation of distortion (e.g. to simulate guitar amplifiers), or vocoder. This type of effects is applied preferably on a limited (preferably single) set of audio objects.

Fig 3 shows modifying means 600 for modifying the parametric data when a spectral envelope of an estimated audio signal corresponding to the object or plurality of objects is modified by the insert effect. The units 511 and 512 are estimating, for example, individual audio objects, while the unit 513 estimates the remaining audio objects together. The insert means 530 comprise separate units 531 and 532 that apply insert effects on the estimated signals obtained from the units 511 and 512, respectively. An adder 540 adds up the audio signals provided from the insert means 530 and the estimated audio signal corresponding to the remaining objects, therefore assembling again all the objects together. The resulting modified down-mix signal 503 is further fed into the decoding means 300 of the object-oriented decoder 110.

The insert effects used in the units 531 and 532 are either of the same type or they differ. The insert effect used by the unit 532 is for example a non-linear distortion that generates additional high frequency spectral components, or a multi-band compressor. If the spectral characteristic of the modified audio signal has changed, applying the unmodified parameters comprised in the parametric data as received in the decoding means 300, might lead to undesired and possibly annoying artifacts. Therefore, adapting the parametric data to match the new spectral characteristics improves the quality of the resulting audio signal. This adaptation of the parametric data is performed in the unit 600. The adapted parametric data 504 is fed into the decoding means 300 and is used for decoding of the modified down-mix signal(s) 503.

It should be noted that the two units 531 and 532 comprised in the insert means 530 are just an example. The number of the units can vary depending on the number of insert effects to be applied. Further, the units 531 and 532 can be implemented in hardware or software.

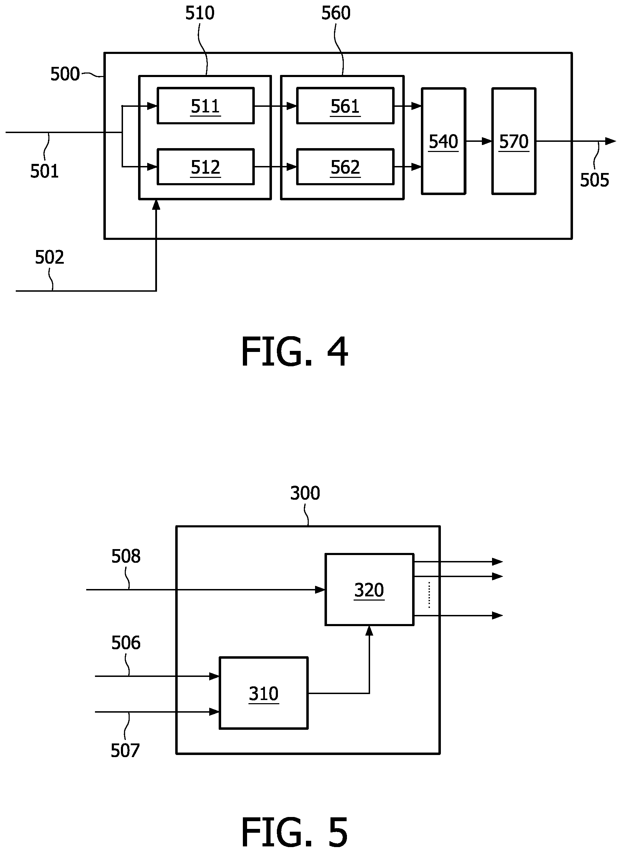

Fig 4 shows an example of effect means for a send effect. The down-mix signals 501 are fed into the effect means 500, these signals are fed in parallel to units 511 and 512 that are comprised in estimation means 510. The estimation means 510 generate the estimated audio signals corresponding to an object or plurality of objects to which the send effect is to be applied. Said estimation is based on the parametric data 502 that is obtained from the receiver 200. Consequently gains are applied by gain means 560 on the estimated audio signals corresponding to an object or plurality of objects obtained from the estimation means 510. Gains, which also could be referred as weights, determine an amount of the effect per object or plurality of objects. Each of units 561 and 562 applies gain to individual audio signals obtained from the estimating means. Each of these units might apply various gains. An adder 540 adds up the audio signals provided from the gain means 560, and a unit 570 applies the send effect. The resulting signal 505, also called the "wet" output, is fed into the rendering means, or alternatively, is mixed with (or added to) the output of the rendering means.

The examples of the send effects are among others reverberation, modulation effects such e.g. chorus, flanger, or phaser.

It should be noted that the two units 561 and 562 comprised in the gain means 560 are just an example. The number of the units can very depending on the number of signals corresponding to audio objects or plurality of audio objects for which the level of the send effect is to be set.

The estimation means 510 and the gain means 560 can be combined in a single processing step that estimates a weighted combination of multiple object signals. The gains 561 and 562 can be incorporated in the estimation means 511 and 512, respectively. This is also described in the equations below, where Q is a (estimation of a) weighted combination of object signals and is obtained by one single scaling operation per time/frequency tile.

The gains per object or combination of objects can be interpreted as 'effect send levels'. In several applications, the amount of effect is preferably user-controllable per object. For example, the user might desire one of the objects without reverberation, another object with a small amount of reverberation, and yet another object with full reverberation. In such an example, the gains per object could be equal to 0, 0.5 and 1.0, for each of the respective objects.

In an embodiment, the generation of the estimated audio signals corresponding to an audio object or plurality of objects comprises time/frequency dependent scaling of the down-mix audio signals based on the power parameters corresponding to audio objects, said power parameters being comprised in the parametric data.

This embodiment is explained for the following example. At the encoder I object signals $s_i[n]$, i=0,...,I-1, with $n$ the sample index are down-mixed to create a down-mix signal $x[n]$, by summation of the down-mix signals:

$$x[n] = \sum_i s_i[n]$$

The down-mix signal is accompanied by object-oriented parameters that describe the (relative) signal power of each object within individual time/frequency tiles of the down-mix signal $x[n]$. The object signals $s_i[n]$ are e.g. first windowed using overlapping analysis windows $w[n]$:

$$s_i[n,m] = s_i[n + mL/2]w[n],$$

With $L$ the length of the window and e.g. $L/2$ the corresponding hop size (assuming 50% overlap), and $m$ the window index. A typical form of the analysis window is a Hanning window:

$$w[n] = \sin\left(\frac{\pi n}{L}\right).$$

The resulting segmented signals $s_i[n,m]$ are subsequently transformed to the frequency domain using an FFT:

$$S_i[k,m] = \sum_n s_i[n,m]e^{-2\pi jkn/L},$$

With $k$ the FFT bin index. The FFT bin indices $k$ are subsequently grouped into parameter bands $b$. In other words, each parameter band $b$ corresponds to a set of adjacent frequency bin indices $k$. For each parameter band $b$, and each segment $m$ of each object signal $S_i[k,m]$, a power value $\sigma_i^2[b,m]$ is computed:

$$\sigma_i^2[b,m] = \frac{\sum_{k=k(b)}^{k=k(b+1)-1} S_i[k,m]S_i^*[k,m]}{k(b+1)-k(b)},$$

with (*) being the complex conjugation operator. These parameters $\sigma_i^2[b,m]$ are comprised in the parametric data (preferably quantized in the logarithmic domain).

The estimation process of an object or plurality of objects at the object-oriented audio decoder comprises time/frequency dependent scaling of the down mix audio signal. A discrete-time down-mix signal $x[n]$ with $n$ the same index is split into time/frequency tiles $X[k,m]$ with $k$ a frequency index and $m$ a frame (temporal segment) index. This is achieved by e.g. windowing the signal $x[n]$ with an analysis window $w[n]$:

$$x[n,m] = x[n + mL/2]w[n],$$

With $L$ the window length and $L/2$ the corresponding hop size. In this case, a preferred analysis window is given by the *square root* of the Hanning window:

$$w[n] = \sqrt{\sin\left(\frac{\pi n}{L}\right)}$$

Subsequently, the windowed signal $x[n,m]$ is transformed to the frequency domain using an FFT:

$$X[k,m] = \sum_n x[n,m]e^{-2\pi jkn/L},$$

The frequency-domain components of $X[k,m]$ are subsequently grouped into so-called parameter bands $b$ ($b=0,...,B$-1). These parameter bands coincide with the parameter bands at the encoder. The decoder-side estimate $\hat{S}_i[k,m]$ of segment $m$ of object $i$ is given by:

$$\hat{S}_i[k,m] = X[k,m]\sqrt{\frac{\sigma_i^2[b(k),m]}{\sum_i \sigma_i^2[b(k),m]}},$$

With $b(k)$ the parameter band that was associated with frequency index $k$. A weighted combination $Q$ of object signals $S_i$ with weights $g_i$ is given by:

$$Q[k,m] = \sum_i g_i S_i[k,m].$$

In the object-oriented decoder, $Q$ can be estimated according to:

$$\hat{Q}[k,m] = \sum_i g_i \hat{S}_i[k,m] = X[k,m]\sqrt{\frac{g_i^2\sigma_i^2[b(k),m]}{\sum_i \sigma_i^2[b(k),m]}}.$$

In other words, an object signal or any linear combination of plurality of audio object signals can be estimated at the proposed object-oriented audio decoder by a time-frequency dependent scaling of the down-mix signal $X[k,m]$.

In order to result in time-domain output signals, each estimated object signal is transformed to the time domain (using an inverse FFT), multiplied by a synthesis window (identical to the analysis window), and combined with previous frames using overlap-add.

In an embodiment, the generation of the estimated audio signals comprises weighting an object or a combination of a plurality of objects by means of time/frequency dependent scaling of the down-mix audio signals based on the power parameters corresponding to audio objects, said power parameters being comprised in the received parametric data.

It should be noted that a send effect unit might have more output signals than input signals. For example in the case of a stereo or multi-channel reverberation unit has a mono input signal.

In an embodiment, the down-mixed signal and the parametric data are in accordance with an MPEG Surround standard. The existing MPEG Surround decoder next to decoding functionality also functions as a rendering device. In such a case, no intermediate audio signals corresponding to the decode objects are required. The object decoding and rendering are combined into a single device.

Fig 5 shows decoding means the decoding means 300 comprise a decoder 320 in accordance with the MPEG Surround standard and conversion means 310 for converting the parametric data into parametric data in accordance with the MPEG Surround standard. The signal(s) 508 corresponding to the down-mix signal(s) 501 or the modified down-mix signal(s) 503, when the insert effects are applied, is fed into the MPEG Surround decoder 320. The conversion means 310 based on the parametric data 506 and the user-control data 507 converts the parametric data into parametric data in accordance with the MPEG Surround standard. The parametric data 506 is the parametric data 502 or the modified parametric data 504, when the spectral envelope of an estimated audio signal corresponding to the object or plurality of objects is modified by the insert effect. The user-control data 507 may for example indicate the desired spatial position of one or plurality of audio objects.

According to one of embodiments, the method comprises the steps of receiving at least one down-mix audio signal and parametric data, generating modified down-mix audio signals, decoding the audio objects from the down-mix audio signals, and generating at least one output audio signal from the decoded audio objects. In the method each down-mix audio signal comprises a down-mix of a plurality of audio objects. The parametric data comprises a plurality of object parameters for each of the plurality of audio objects. The modified down-mix audio signals are obtained by applying effects to estimated audio signals corresponding to audio objects comprised in said down-mix audio signals. The estimated audio signals are derived from the down-mix audio signals based on the parametric data. The modified down-mix audio signals based on a type of the applied effect are decoded by decoding means 300 or rendered by rendering means 400. The decoding step is performed by the decoding means 300 for the down-mix audio signals or the modified down-mix audio signals based on the parametric data.

The last step of generating at least one output audio signal from the decoded audio objects, which can be called a rendering step, can be combined with the decoding step into one processing step.

In an embodiment a receiver for receiving audio signals comprises: a receiving element, effect means, decoding means, and rendering means. The receiver element receives from a transmitter at least one down-mix audio signal and parametric data. Each down-mix audio signal comprises a down-mix of a plurality of audio objects. The parametric data comprises a plurality of object parameters for each of the plurality of audio objects.

The effect means generate modified down-mix audio signals. These modified down-mix audio signals are obtained by applying effects to estimated audio signals corresponding to audio objects comprised in said down-mix audio signals. The estimated audio signals are derived from the down-mix audio signals based on the parametric data. The modified down-mix audio signals based on a type of the applied effect are decoded by decoding means or rendered by rendering means.

The decoding means decode the audio objects from the down-mix audio signals or the modified down-mix audio signals based on the parametric data. The rendering means generate at least one output audio signal from the decoded audio objects.

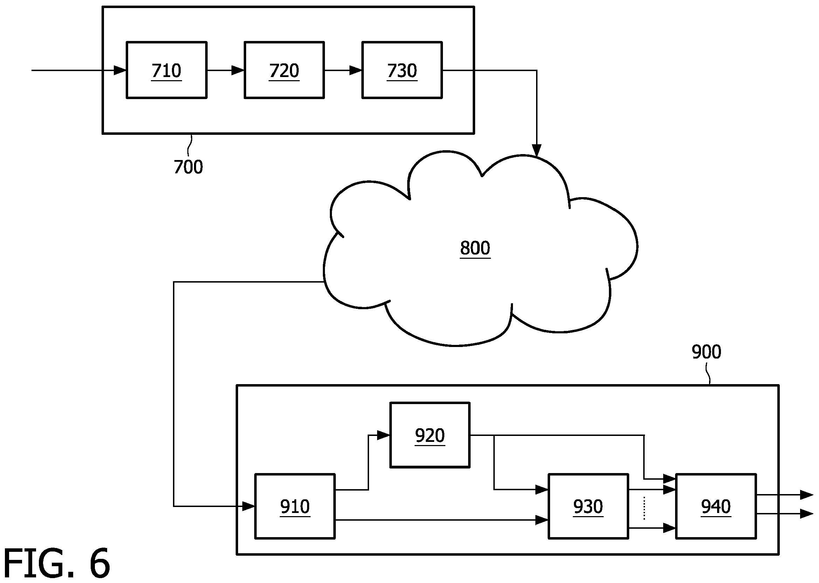

Fig 6 shows a transmission system for communication of an audio signal in accordance with some embodiments of the invention. The transmission system comprises a transmitter 700, which is coupled with a receiver 900 through a network 800. The network 800 could be e.g. Internet.

The transmitter 700 is for example a signal recording device and the receiver 900 is for example a signal player device. In the specific example when a signal recording function is supported, the transmitter 700 comprises means 710 for receiving a plurality of audio objects. Consequently, these objects are encoded by encoding means 720 for encoding the plurality of audio objects in at least one down-mix audio signal and parametric data. An embodiment of such encoding means 620 is given in Faller, C., "Parametric joint-coding of audio sources", Proc. 120th AES Convention, Paris, France, May 2006. Each down-mix audio signal comprises a down-mix of a plurality of audio objects. Said parametric data comprises a plurality of object parameters for each of the plurality of audio objects. The encoded audio objects are transmitted to the receiver 900 by means 730 for transmitting down-mix audio signals and the parametric data. Said means 730 have an interface with the network 800, and may transmit the down-mix signals through the network 800.

The receiver 900 comprises a receiver element 910 for receiving from the transmitter 700 at least one down-mix audio signal and parametric data. Each down-mix audio signal comprises a down-mix of a plurality of audio objects. Said parametric data comprises a plurality of object parameters for each of the plurality of audio objects. The effect means 920 generate modified down-mix audio signals. Said modified down-mix audio signals are obtained by applying effects to estimated audio signals corresponding to audio objects comprised in said down-mix audio signals. Said estimated audio signals are derived from the down-mix audio signals based on the parametric data. Said modified down-mix audio signals based on a type of the applied effect are decoded by decoding means, or rendered by rendering means, or combined with the output of rendering means. The decoding means decode the audio objects from the down-mix audio signals or the modified down-mix audio signals based on the parametric data. The rendering means generate at least one output audio signal from the decoded audio objects.

In an embodiment, the insert and send effects are applied simultaneously.

In an embodiment, the effects are applied in response to user input. The user can by means of e.g. button, slider, knob, or graphical user interface, set the effects according to own preferences.

It should be noted that the above-mentioned embodiments illustrate rather than limit the invention, and those skilled in the art will be able to design many alternative embodiments without departing from the scope of the appended claims.

In the accompanying claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements, and by means of a suitably programmed computer.

**Claims**

1.  An audio decoder (100) comprising:
    effect means (500) for generating modified down-mix audio signals from received down-mix audio signals, said received down-mix audio signals comprising a down-mix of a plurality of audio objects, the effect means being arranged to:

    generate estimated audio signals from the received down-mix audio signals based on received parametric data comprising a plurality of object parameters for each of the plurality of audio objects, the estimated audio signals corresponding to one or more audio objects comprised in said received down-mix audio signals, and
    obtain said modified down-mix audio signals by applying effects to the estimated audio signals;
    decoding means (300) being arranged for decoding the audio objects from the down-mix audio signals or the modified down-mix audio signals based on the parametric data;
    rendering means (400) being arranged for generating at least one output audio signal from the decoded audio objects; wherein
    the audio decoder is, based on a type of the applied effect, arranged to:

    for the type of applied effect being an insert effect, decode said modified down-mix audio signals by the decoding means; or
    for the type of applied effect being a send effect, rendering said modified down-mix audio signals by the rendering means or combining said modified down-mix audio signals with the output of rendering means; and

    the generation of the estimated audio signals comprises time/frequency dependent scaling of the down-mix audio signals based on power parameters corresponding to audio objects, said power parameters being comprised in the parametric data.

2.  A decoder as claimed in claim 1, wherein the effect means (500) are arranged for providing an insert effect and comprise:

    estimation means (510) for generating the estimated audio signals corresponding to an object or plurality of objects to which the insert effect is to be applied, and generating the estimated audio signal corresponding to the remaining objects;
    insert means (530) for applying the insert effect on the estimated audio signals corresponding to an object or plurality of objects to which the insert effect is to be applied;
    an adder (540) for adding up the audio signals provided from the insert means and the estimated audio signal corresponding to the remaining objects.

3. A decoder as claimed in claim 2, wherein the decoder further comprises modifying means (600) for modifying the parametric data when a spectral or temporal envelope of an estimated audio signal corresponding to the object or plurality of objects is modified by the insert effect.

4. A decoder as claimed in claim 1, wherein the effect means are arranged for providing a send effect and comprise:

estimation means (510) for generating the estimated audio signals corresponding to an object or plurality of objects to which the send effect is to be applied;
gain means (560) for determining an amount of the send effect for the estimated audio signals corresponding to the object or plurality of objects to which the send effect is to be applied;
an adder (540) for adding the audio signals obtained from the gain means;
send means (570) for applying the send effect on the audio signals obtained from the adder.

5. A decoder as claimed in claim 1, wherein the generation of the estimated audio signals comprises weighting an object or a combination of a plurality of objects by means of time/frequency dependent scaling of the down-mix audio signals based on the power parameters corresponding to audio objects, said power parameters being comprised in the received parametric data.

6. A decoder as claimed in claim 1, wherein the down-mixed signal and the parametric data are in accordance with an MPEG Surround standard.

7. A decoder as claimed in claim 6, wherein the decoding means (300) comprise a decoder (320) in accordance with the MPEG Surround standard and conversion means (310) for converting the parametric data into parametric data in accordance with the MPEG Surround standard.

8. A method of decoding audio signals, the method comprising:

receiving at least one down-mix audio signal and parametric data, each down-mix audio signal comprising a down-mix of a plurality of audio objects, said parametric data comprising a plurality of object parameters for each of the plurality of audio objects;
generating estimated audio signals from the received down-mix audio signals based on received parametric data comprising a plurality of object parameters for each of the plurality of audio objects, the estimated audio signals corresponding to one or more audio objects comprised in said received down-mix audio signals;
generating modified down-mix audio signals; said modified down-mix audio signals obtained by applying effects to estimated audio signals;
decoding the audio objects from the down-mix audio signals or the modified down-mix audio signals based on the parametric data; and
generating at least one output audio signal from the decoded audio objects, wherein generating at least one output audio signal includes, based on a type of the applied effect, performing the steps of:

for the type of applied effect being an insert effect, decoding said modified down-mix audio signals, or
for the type of applied effect being a send effect, rendering said modified down-mix audio signals or combining said modified down-mix audio signals with an output from a rendering means for rendering the decoded audio objects;

wherein
generating the estimated audio signals comprises time/frequency dependent scaling of the down-mix audio signals based on power parameters corresponding to audio objects, said power parameters being comprised in the parametric data.

9. A receiver for receiving audio signals, the receiver comprising the audio decoder of claim 1 and a receiver element (200) for receiving from a transmitter at least one down-mix audio signal and parametric data, each down-mix audio signal comprising a down-mix of a plurality of audio objects, said parametric data comprising a plurality of object parameters for each of the plurality of audio objects, the receiver element being coupled to the effect means (500) and the decoding means (300).

10. A communication system for communicating audio signals, the communication system comprising:

a transmitter (700) comprising:

means (710) for receiving a plurality of audio objects,
encoding means (720) for encoding the plurality of audio objects in at least one down-mix audio signal and parametric data, each down-mix audio signal comprising a down-mix of a plurality of audio objects, said parametric data comprising a plurality of object parameters for each of the plurality of audio objects, and means (730) for transmitting down-mix audio signals and the parametric data to a receiver; and the receiver (900) as claimed in claim 9.

**11.** A method of receiving audio signals, the method comprising:

receiving from a transmitter at least one down-mix audio signal and parametric data, each down-mix audio signal comprising a down-mix of a plurality of audio objects, said parametric data comprising a plurality of object parameters for each of the plurality of audio objects; and the method of decoding claimed in claim 8.

**12.** A method of transmitting and receiving audio signals, the method comprising:

at a transmitter performing the steps of:

receiving a plurality of audio objects,
encoding the plurality of audio objects in at least one down-mix audio signal and parametric data, each down-mix audio signal comprising a down-mix of a plurality of audio objects, said parametric data comprising a plurality of object parameters for each of the plurality of audio objects, and transmitting down-mix audio signals and the parametric data to a receiver; and

at the receiver performing the steps of:

receiving from the transmitter at least one down-mix audio signal and parametric data, each down-mix audio signal comprising a down-mix of a plurality of audio objects, said parametric data comprising a plurality of object parameters for each of the plurality of audio objects;
generating estimated audio signals from the received down-mix audio signals based on received parametric data comprising a plurality of object parameters for each of the plurality of audio objects, the estimated audio signals corresponding to one or more audio objects comprised in said received down-mix audio signals;
generating modified down-mix audio signals; said modified down-mix audio signals obtained by applying effects to estimated audio signals;
decoding the audio objects from the down-mix audio signals or the modified down-mix audio signals based on the parametric data;
generating at least one output audio signal from the decoded audio objects; wherein generating at least one output audio signal includes, based on a type of the applied effect, performing the steps of:

for the type of applied effect being an insert effect, decoding said modified down-mix audio signals, or for the type of applied effect being a send effect, rendering said modified down-mix audio signals or combining said modified down-mix audio signals with an output from a rendering means for rendering the decoded audio objects;

wherein
generating the estimated audio signals comprises time/frequency dependent scaling of the down-mix audio signals based on power parameters corresponding to audio objects, said power parameters being comprised in the parametric data.

**13.** A method claimed in any one of claims 8, 11, and 12, wherein the effects are applied in response to user input.

**14.** A computer program product for enabling a programmable device including a receiver and/or a transmitter to perform the method of any one of claims 8, 11, and 12.

**Patentansprüche**

1. Audiodecodierer (100), umfassend:

   Effektmittel (500) zum Generieren modifizierter Abwärtsmisch-Audiosignale aus empfangenen Abwärtsmisch-Audiosignalen, wobei die empfangenen Abwärtsmisch-Audiosignale eine Abwärtsmischung einer Vielzahl von Audioobjekten umfassen, wobei die Effektmittel angeordnet sind zum:

   Generieren geschätzter Audiosignale aus den empfangenen Abwärtsmisch-Audiosignalen auf Basis von empfangenen parametrischen Daten, die eine Vielzahl von Objektparametern für jedes der Vielzahl von Audioobjekten umfassen, wobei die geschätzten Audiosignale einem oder mehreren Audioobjekten entsprechen, die in den empfangenen Abwärtsmisch-Audiosignalen enthalten sind, und
   Erhalten der modifizierten Abwärtsmisch-Audiosignale durch Anwenden von Effekten an den geschätzten Audiosignalen;

   Decodiermittel (300), die zum Decodieren der Audioobjekte aus den Abwärtsmisch-Audiosignalen oder den modifizierten Abwärtsmisch-Audiosignalen auf Basis der parametrischen Daten angeordnet sind;
   Wiedergabemittel (400), die zum Generieren zumindest eines Ausgangsaudiosignals aus den decodierten Audioobjekten angeordnet sind; wobei
   der Audiodecodierer, auf Basis einer Art des angewendeten Effekts, angeordnet ist zum:

   falls die Art von angewendetem Effekt ein Einsetzeffekt ist, Decodieren der modifizierten Abwärtsmisch-Audiosignale durch die Decodiermittel; oder
   falls die Art von angewendetem Effekt ein Sendeeffekt ist, Wiedergeben der modifizierten Abwärtsmisch-Audiosignale durch die Wiedergabemittel oder Kombinieren der modifizierten Abwärtsmisch-Audiosignale mit dem Ausgang der Wiedergabemittel; und

   das Generieren der geschätzten Audiosignale ein zeit-/frequenzabhängiges Skalieren der Abwärtsmisch-Audiosignale auf Basis von Leistungsparametern umfasst, die Audioobjekten entsprechen, wobei die Leistungsparameter in den parametrischen Daten enthalten sind.

2. Decodierer nach Anspruch 1, wobei die Effektmittel (500) zum Bereitstellen eines Einsetzeffekts angeordnet sind und umfassen:

   Schätzungsmittel (510) zum Generieren der geschätzten Audiosignale entsprechend einem Objekt oder einer Vielzahl von Objekten, bei welchen der Einsetzeffekt angewendet werden soll, und Generieren des geschätzten Audiosignals entsprechend den verbleibenden Objekten;
   Einsetzmittel (530) zum Anwenden des Einsetzeffekts an den geschätzten Audiosignalen entsprechend einem Objekt oder einer Vielzahl von Objekten, bei welchen der Einsetzeffekt angewendet werden soll;
   einen Addierer (540) zum Addieren der Audiosignale, die von den Einsetzmitteln bereitgestellt werden, und des geschätzten Audiosignals entsprechend den verbleibenden Objekten.

3. Decodierer nach Anspruch 2, wobei der Decodierer weiter Modifizierungsmittel (600) zum Modifizieren der parametrischen Daten umfasst, wenn eine spektrale oder zeitliche Hülle eines geschätzten Audiosignals entsprechend dem Objekt oder der Vielzahl von Objekten durch den Einsetzeffekt modifiziert wird.

4. Decodierer nach Anspruch 1, wobei die Effektmittel zum Bereitstellen eines Sendeeffekts angeordnet sind und umfassen:

   Schätzungsmittel (510) zum Generieren der geschätzten Audiosignale entsprechend einem Objekt oder einer Vielzahl von Objekten, bei welchen der Sendeeffekt angewendet werden soll;
   Verstärkungsmittel (560) zum Bestimmen eines Ausmaßes des Sendeeffekts für die geschätzten Audiosignale entsprechend dem Objekt oder der Vielzahl von Objekten, bei welchen der Sendeeffekt angewendet werden soll;
   einen Addierer (540) zum Addieren der Audiosignale, die von den Verstärkungsmitteln erhalten werden;
   Sendemittel (570) zum Anwenden des Sendeeffekts an den Audiosignalen, die vom Addierer erhalten werden.

5. Decodierer nach Anspruch 1, wobei das Generieren der geschätzten Audiosignale ein Gewichten eines Objekts oder einer Kombination einer Vielzahl von Objekten mittels zeit-/frequenzabhängigem Skalieren der Abwärtsmisch-Audiosignale auf Basis der Leistungsparameter entsprechend Audioobjekten umfasst, wobei die Leistungsparameter in den parametrischen Daten enthalten sind.

6. Decodierer nach Anspruch 1, wobei das abwärts gemischte Audiosignal und die parametrischen Daten einem MPEG Surround-Standard entsprechen.

7. Decodierer nach Anspruch 6, wobei die Decodiermittel (300) einen Decodierer (320) gemäß dem MPEG Surround-Standard und Umwandlungsmittel (310) zum Umwandeln der parametrischen Daten in parametrische Daten gemäß dem MPEG Surround-Standard umfassen.

8. Verfahren zum Decodieren von Audiosignalen, das Verfahren umfassend:

Empfangen zumindest eines Abwärtsmisch-Audiosignals und parametrischer Daten, wobei jedes Abwärtsmisch-Audiosignal eine Abwärtsmischung einer Vielzahl von Audioobjekten umfasst, die parametrischen Daten eine Vielzahl von Objektparametern für jedes der Vielzahl von Audioobjekten umfassen;
Generieren geschätzter Audiosignale aus den empfangenen Abwärtsmisch-Audiosignalen auf Basis von empfangenen parametrischen Daten, die eine Vielzahl von Objektparametern für jedes der Vielzahl von Audioobjekten umfassen, wobei die geschätzten Audiosignale einem oder mehreren Audioobjekten entsprechen, die in den empfangenen Abwärtsmisch-Audiosignalen enthalten sind;
Generieren modifizierter Abwärtsmisch-Audiosignale; wobei die modifizierten Abwärtsmisch-Audiosignale durch Anwenden von Effekten an den geschätzten Audiosignalen erhalten werden;
Decodieren der Audioobjekte aus den Abwärtsmisch-Audiosignalen oder den modifizierten Abwärtsmisch-Audiosignalen auf Basis der parametrischen Daten; und
Generieren zumindest eines Ausgangsaudiosignals aus den decodierten Audioobjekten, wobei ein Generieren zumindest eines Ausgangsaudiosignals, auf Basis einer Art des angewendeten Effekts, ein Durchführen der Schritte enthält:

falls die Art von angewendetem Effekt ein Einsetzeffekt ist, Decodieren der modifizierten Abwärtsmisch-Audiosignale, oder
falls die Art von angewendetem Effekt ein Sendeeffekt ist, Wiedergeben der modifizierten Abwärtsmisch-Audiosignale oder Kombinieren der modifizierten Abwärtsmisch-Audiosignale mit einem Ausgang aus einem Wiedergabemittel zum Wiedergeben der decodierten Audioobjekte; wobei

das Generieren der geschätzten Audiosignale ein zeit-/frequenzabhängiges Skalieren der Abwärtsmisch-Audiosignale auf Basis von Leistungsparametern umfasst, die Audioobjekten entsprechen, wobei die Leistungsparameter in den parametrischen Daten enthalten sind.

9. Empfänger zum Empfangen von Audiosignalen, wobei der Empfänger den Audiodecodierer nach Anspruch 1 und ein Empfängerelement (200) zum Empfangen zumindest eines Abwärtsmisch-Audiosignals und parametrischer Daten von einem Sender umfasst, wobei jedes Abwärtsmisch-Audiosignal eine Abwärtsmischung einer Vielzahl von Audioobjekten umfasst, die parametrischen Daten eine Vielzahl von Objektparametern für jedes der Vielzahl von Audioobjekten umfassen, das Empfängerelement an das Effektmittel (500) und das Decodiermittel (300) gekoppelt ist.

10. Kommunikationssystem zum Kommunizieren von Audiosignalen, wobei das Kommunikationssystem umfasst:

einen Sender (700), umfassend:

Mittel (710) zum Empfangen einer Vielzahl von Audioobjekten,
Codiermittel (720) zum Codieren der Vielzahl von Audioobjekten in zumindest einem Abwärtsmisch-Audiosignal und parametrischer Daten, wobei jedes Abwärtsmisch-Audiosignal eine Abwärtsmischung einer Vielzahl von Audioobjekten umfasst, die parametrischen Daten eine Vielzahl von Objektparametern für jedes der Vielzahl von Audioobjekten umfassen, und
Mittel (730) zum Senden von Abwärtsmisch-Audiosignalen und den parametrischen Daten zu einem Empfänger; und
den Empfänger (900) nach Anspruch 9.

11. Verfahren zum Empfangen von Audiosignalen, das Verfahren umfassend:

Empfangen von einem Sender zumindest eines Abwärtsmisch-Audiosignals und parametrischer Daten, wobei jedes Abwärtsmisch-Audiosignal eine Abwärtsmischung einer Vielzahl von Audioobjekten umfasst, die parametrischen Daten eine Vielzahl von Objektparametern für jedes der Vielzahl von Audioobjekten umfassen; und das Verfahren zum Decodieren nach Anspruch 8.

**12.** Verfahren zum Senden und Empfangen von Audiosignalen, das Verfahren umfassend:

bei einem Sender, Durchführen der Schritte:

Empfangen einer Vielzahl von Audioobjekten,
Codieren der Vielzahl von Audioobjekten in zumindest einem Abwärtsmisch-Audiosignal und parametrischer Daten, wobei jedes Abwärtsmisch-Audiosignal eine Abwärtsmischung einer Vielzahl von Audioobjekten umfasst, die parametrischen Daten eine Vielzahl von Objektparametern für jedes der Vielzahl von Audioobjekten umfassen, und
Senden von Abwärtsmisch-Audiosignalen und den parametrischen Daten zu einem Empfänger; und

bei einem Empfänger, Durchführen der Schritte:

Empfangen zumindest eines Abwärtsmisch-Audiosignals und parametrischer Daten von einem Sender, wobei jedes Abwärtsmisch-Audiosignal eine Abwärtsmischung einer Vielzahl von Audioobjekten umfasst, die parametrischen Daten eine Vielzahl von Objektparametern für jedes der Vielzahl von Audioobjekten umfassen;
Generieren geschätzter Audiosignale aus den empfangenen Abwärtsmisch-Audiosignalen auf Basis von empfangenen parametrischen Daten, die eine Vielzahl von Objektparametern für jedes der Vielzahl von Audioobjekten umfassen, wobei die geschätzten Audiosignale einem oder mehreren Audioobjekten entsprechen, die in den empfangenen Abwärtsmisch-Audiosignalen enthalten sind;
Generieren modifizierter Abwärtsmisch-Audiosignale; wobei die modifizierten Abwärtsmisch-Audiosignale durch Anwenden von Effekten an den geschätzten Audiosignalen erhalten werden;
Decodieren der Audioobjekte aus den Abwärtsmisch-Audiosignalen oder den modifizierten Abwärtsmisch-Audiosignalen auf Basis der parametrischen Daten;
Generieren zumindest eines Ausgangsaudiosignals aus den decodierten Audioobjekten, wobei ein Generieren zumindest eines Ausgangsaudiosignals, auf Basis einer Art des angewendeten Effekts, ein Durchführen der Schritte enthält:

falls die Art von angewendetem Effekt ein Einsetzeffekt ist, Decodieren der modifizierten Abwärtsmisch-Audiosignale, oder
falls die Art von angewendetem Effekt ein Sendeeffekt ist, Wiedergeben der modifizierten Abwärtsmisch-Audiosignale oder Kombinieren der modifizierten Abwärtsmisch-Audiosignale mit einem Ausgang aus einem Wiedergabemittel zum Wiedergeben der decodierten Audioobjekte; wobei

das Generieren der geschätzten Audiosignale ein zeit-/frequenzabhängiges Skalieren der Abwärtsmisch-Audiosignale auf Basis von Leistungsparametern umfasst, die Audioobjekten entsprechen, wobei die Leistungsparameter in den parametrischen Daten enthalten sind.

**13.** Verfahren nach einem der Ansprüche 8, 11 und 12, wobei die Effekte in Antwort auf eine Benutzereingabe angewendet werden.

**14.** Computerprogrammprodukt zum Ermöglichen, dass eine programmierbare Vorrichtung, die einen Empfänger und/oder einen Sender enthält, das Verfahren nach einem der Ansprüche 8, 11 und 12 durchführt.

**Revendications**

**1.** Décodeur audio (100) comprenant :

des moyens d'effets (500) pour générer des signaux audio de mélange abaisseur modifiés à partir de signaux audio de mélange abaisseur reçus, lesdits signaux audio de mélange abaisseur reçus comprenant un mélange abaisseur d'une pluralité d'objets audio, les moyens de réalisation étant agencés pour :

générer des signaux audio estimés à partir des signaux audio de mélange abaisseur reçus sur la base de données paramétriques reçues comprenant une pluralité de paramètres d'objets pour chacun de la pluralité d'objets audio, les signaux audio estimés correspondant à un ou plusieurs objets audio compris dans lesdites signaux audio de mélange abaisseur reçus et

obtenir lesdits signaux audio de mélange abaisseur modifiés en appliquant des effets aux signaux audio estimés ;

des moyens de décodage (300) étant agencés pour décoder les objets audio à partir des signaux audio de mélange abaisseur ou des signaux audio de mélange abaisseur modifiés sur la base des données paramétriques ;

des moyens de rendu (400) étant agencés pour générer au moins un signal audio de sortie à partir des objets audio décodés ; dans lequel

le décodeur audio est, sur la base d'un type de l'effet appliqué, agencé pour :

lorsque le type d'effet appliqué est un effet d'insertion, décoder lesdits signaux audio de mélange abaisseur modifiés par les moyens de décodage ; ou,

lorsque le type d'effet appliqué est un effet d'envoi, rendre lesdits signaux audio de mélange abaisseur modifiés par les moyens de rendu ou combiner lesdits signaux audio de mélange abaisseur modifiés avec la sortie de moyens de rendu ; et

la génération des signaux audio estimés comprend la mise à l'échelle en fonction du temps ou de la fréquence des signaux audio de mélange abaisseur sur la base de paramètres de puissance correspondant à des objets audio, lesdits paramètres de puissance étant compris dans les données paramétriques.

2. Décodeur selon la revendication 1, dans lequel les moyens d'effets (500) sont agencés pour fournir un effet d'insertion et comprennent :

des moyens d'estimation (510) pour générer les signaux audio estimés correspondant à un objet ou à une pluralité d'objets auxquels l'effet d'insertion doit être appliqué et générer le signal audio estimé correspondant aux objets restants ;

des moyens d'insertion (530) pour appliquer l'effet d'insertion sur les signaux audio estimés correspondant à un objet ou à une pluralité d'objets auxquels l'effet d'insertion doit être appliqué ;

un additionneur (540) pour additionner les signaux audio fournis par les moyens d'insertion et le signal audio estimé correspondant aux objets restants.

3. Décodeur selon la revendication 2, dans lequel le décodeur comprend en outre des moyens de modification (600) pour modifier les données paramétriques lorsqu'une enveloppe spectrale ou temporelle d'un signal audio estimé correspondant à l'objet ou à la pluralité d'objets est modifiée par l'effet d'insertion.

4. Décodeur selon la revendication 1, dans lequel les moyens d'effets sont agencés pour fournir un effet d'envoi et comprennent :

des moyens d'estimation (510) pour générer les signaux audio estimés correspondant à un objet ou à une pluralité d'objets auxquels l'effet d'envoi doit être appliqué ;

des moyens de gain (560) pour déterminer une quantité de l'effet d'envoi pour les signaux audio estimés correspondant à l'objet ou à la pluralité d'objets auxquels l'effet d'envoi doit être appliqué ;

un additionneur (540) pour ajouter les signaux audio tirés des moyens de gain ;

des moyens d'envoi (570) pour appliquer l'effet d'envoi sur les signaux audio tirés de l'additionneur.

5. Décodeur selon la revendication 1, dans lequel la génération des signaux audio estimés comprend la pondération d'un objet ou d'une combinaison d'une pluralité d'objets au moyen d'une mise à l'échelle en fonction du temps ou de la fréquence des signaux audio de mélange abaisseur sur la base des paramètres de puissance correspondant à des objets audio, lesdits paramètres de puissance étant compris dans les données paramétriques reçues.

6. Décodeur selon la revendication 1, dans lequel le signal de mélange abaisseur et les données paramétriques sont conformes à une norme d'ambiance MPEG.

7. Décodeur selon la revendication 6, dans lequel les moyens de décodage (300) comprennent un décodeur (320) conformément à la norme d'ambiance MPEG et des moyens de conversion (310) pour convertir les données paramétriques en données paramétriques conformes à la norme d'ambiance MPEG.

8. Procédé de décodage de signaux audio, le procédé comprenant :

la réception d'au moins un signal audio de mélange abaisseur et des données paramétriques, chaque signal audio de mélange abaisseur comprenant un mélange abaisseur d'une pluralité d'objets audio, lesdites données paramétriques comprenant une pluralité de paramètres d'objets pour chacun de la pluralité d'objets audio ;
la génération de signaux audio estimés à partir des signaux audio de mélange abaisseur reçus sur la base de données paramétriques reçues comprenant une pluralité de paramètres d'objets pour chacun de la pluralité d'objets audio, les signaux audio estimés correspondant à un ou plusieurs objets audio compris dans lesdits signaux audio de mélange abaisseur reçus ;
la génération de signaux audio de mélange abaisseur modifiés ; lesdits signaux audio de mélange abaisseur modifiés étant obtenus en appliquant des effets à des signaux audio estimés ;
le décodage des objets audio à partir des signaux audio de mélange abaisseur ou des signaux audio de mélange abaisseur modifiés sur la base des données paramétriques ; et
la génération d'au moins un signal audio de sortie des objets audio décodés, dans lequel la génération d'au moins un signal audio de sortie inclut, sur la base d'un type de l'effet appliqué, la réalisation des étapes consistant à,

lorsque le type d'effet appliqué est un effet d'insertion, décoder lesdites signaux audio de mélange abaisseur modifiés ou,
lorsque le type d'effet appliqué est un effet d'envoi, rendre lesdits signaux audio de mélange abaisseur modifiés ou combiner lesdits signaux audio de mélange abaisseur modifiés avec une sortie d'un moyen de rendu pour rendre les objets audio décodés ; dans lequel

la génération des signaux audio estimés comprend la mise à l'échelle en fonction du temps ou de la fréquence des signaux audio de mélange abaisseur sur la base de paramètres de puissance correspondant à des objets audio, lesdits paramètres de puissance étant compris dans les données paramétriques.

9. Récepteur pour recevoir des signaux audio, le récepteur comprenant le décodeur audio de la revendication 1 et un élément récepteur (200) pour recevoir d'un émetteur au moins un signal audio de mélange abaisseur et des données paramétriques, chaque signal audio de mélange abaisseur comprenant un mélange abaisseur d'une pluralité d'objets audio, lesdites données paramétriques comprenant une pluralité de paramètres d'objets pour chacun de la pluralité d'objets audio, l'élément récepteur étant couplé aux moyens d'effets (500) et aux moyens de décodage (300).

10. Système de communication pour communiquer des signaux audio, le système de communication comprenant :

un émetteur (700) comprenant :

des moyens (710) pour recevoir une pluralité d'objets audio,
des moyens de codage (720) pour coder la pluralité d'objets audio dans au moins un signal audio de mélange abaisseur et des données paramétriques, chaque signal audio de mélange abaisseur comprenant un mélange abaisseur d'une pluralité d'objets audio, lesdites données paramétriques comprenant une pluralité de paramètres d'objets pour chacun de la pluralité d'objets audio et
des moyens (730) pour transmettre des signaux audio de mélange abaisseur et les données paramétriques à un récepteur ; et
le récepteur (900) selon la revendication 9.

11. Procédé de réception de signaux audio, le procédé comprenant :

la réception d'un émetteur d'au moins un signal audio de mélange abaisseur et de données paramétriques, chaque signal audio de mélange abaisseur comprenant un mélange abaisseur d'une pluralité d'objets audio, lesdites données paramétriques comprenant une pluralité de paramètres d'objets pour chacun de la pluralité d'objets audio ; et
le procédé de décodage selon la revendication 8.

12. Procédé d'émission et de réception de signaux audio, le procédé comprenant :

dans un émetteur, la réalisation d'étapes consistant à :

recevoir une pluralité d'objets audio,
coder la pluralité d'objets audio en au moins un signal audio de mélange abaisseur et des données paramétriques, chaque signal audio de mélange abaisseur comprenant un mélange abaisseur d'une pluralité d'objets audio, lesdites données paramétriques comprenant une pluralité de paramètres d'objets pour chacun de la pluralité d'objets audio et
transmettre de signaux audio de mélange abaisseur et les données paramétriques à un récepteur ; et
dans le récepteur, la réalisation d'étapes consistant à :

recevoir de l'émetteur au moins un signal audio de mélange abaisseur et des données paramétriques, chaque signal audio de mélange abaisseur comprenant un mélange abaisseur d'une pluralité d'objets audio, lesdites données paramétriques comprenant une pluralité de paramètres d'objets pour chacun de la pluralité d'objets audio ;
générer des signaux audio estimés à partir des signaux audio de mélange abaisseur reçus sur la base de données paramétriques reçues comprenant une pluralité de paramètres d'objets pour chacun de la pluralité d'objets audio, les signaux audio estimés correspondant à un ou plusieurs objets audio compris dans lesdits signaux audio de mélange abaisseur reçus ;
générer des signaux audio de mélange abaisseur modifiés ; lesdits signaux audio de mélange abaisseur modifiés étant obtenus en appliquant des effets aux signaux audio estimés ;
décoder les objets audio à partir des signaux audio de mélange abaisseur ou des signaux audio de mélange abaisseur modifiés sur la base des données paramétriques ;
générer au moins un signal audio de sortie à partir d'objets audio décodés ;
dans lequel la génération d'au moins un signal audio de sortie inclut, sur la base d'un type de l'effet appliqué, la réalisation des étapes consistant à,

lorsque le type d'effet appliqué est un effet d'insertion, décoder lesdits signaux audio de mélange abaisseur modifiés ou
lorsque le type d'effet appliqué est une effet d'envoi, rendre lesdits signaux audio de mélange abaisseur modifiés ou combiner lesdits signaux audio de mélange abaisseur modifiés avec une sortie d'un moyen de rendu pour rendre les objets audio décodés ; dans lequel

la génération des signaux audio estimés comprend la mise à l'échelle en fonction du temps ou de la fréquence des signaux audio de mélange abaisseur sur la base de paramètres de puissance correspondant à des objets audio, lesdits paramètres de puissance étant compris dans les données paramétriques.

**13.** Procédé selon l'une quelconque des revendication 8, 11 et 12, dans lequel les effets sont appliqués en réponse à une entrée utilisateur.

**14.** Produit de programme informatique pour permettre à un dispositif programmable comprenant un récepteur et/ou un émetteur d'effectuer le procédé selon l'une quelconque des revendications 8, 11 et 12.

FIG. 1A

FIG. 1B

EP 2 109 861 B1

500

511

530

540

501

512

510

503

502

# FIG. 2

510

530

500

511

531

540

501

512

532

503

513

502

600

504

# FIG. 3

FIG. 4

FIG. 5

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1565036 A2

**Non-patent literature cited in the description**

- **C. FALLER.** Parametric Joint-Coding of Audio Sources. *AES 120th Convention,* May 2006

- **FALLER, C.** Parametric joint-coding of audio sources. *Proc. 120th AES Convention,* May 2006